# EUROPÄISCHE PATENTSCHRIFT

(11) **EP 1 474 669 B1**
(45) Veröffentlichungstag und Bekanntmachung des Hinweises auf die Patenterteilung: **23.11.2005**
(21) Anmeldenummer: 02712782.8
(22) Anmeldetag: 14.02.2002
(51) Int. Cl.: G01L 1/20, B60R 21/01, G01R 27/14

(54) **VERFAHREN ZUR BESTIMMUNG DES ELEKTRISCHEN WIDERSTANDS EINER ELEKTRISCHEN ZULEITUNG ZU SENSORELEMENTEN SOWIE SENSORANORDNUNG**
METHOD FOR DETERMINING THE ELECTRICAL RESISTANCE OF AN ELECTRICAL SUPPLY LEAD TO SENSOR ELEMENTS, AND A SENSOR ARRANGEMENT
PROCEDE PERMETTANT DE DETERMINER LA RESISTANCE ELECTRIQUE D'UN CABLE D'ALIMENTATION ELECTRIQUE D'ELEMENTS DE DETECTION ET ENSEMBLE DE DETECTION

(43) Veröffentlichungstag der Anmeldung: 10.11.2004
(73) Patentinhaber: SIEMENS AKTIENGESELLSCHAFT, 80333 München (DE)
(72) Erfinder: CRESSWELL, Justin, Lincoln Park, MI 48146 (US); PIETSCH, Arnulf, 93049 Regensburg (DE); WILD, Gerhard, 93057 Regensburg (DE)
(86) Internationale Anmeldenummer: PCT/DE2002/000538
(87) Internationale Veröffentlichungsnummer: WO 2003/069293

(56) Entgegenhaltungen:
- EP-A- 0 895 091
- WO-A-00/54064
- BILLEN K: "Occupant Classification System for Smart Restraint Systems" SAE PAPER 1999-01-0761, XX, XX, Januar 1999 (1999-01), Seiten 33-38, XP002184965 in der Anmeldung erwähnt

## Beschreibung

Die Erfindung betrifft ein Verfahren zur Bestimmung des elektrischen Widerstands einer elektrischen Zuleitung zu Sensorelementen und eine Sensoranordnung, die geeignet ist das Verfahren auf sie anzuwenden.

Bei einer Vielzahl von technischen Anwendungen in Kraftfahrzeugen ist die Sitzbelegung durch Kraftfahrzeuginsassen eine wichtige Eingangsgröße. In besonderen Maße gilt dies für Insassenrückhaltesysteme, deren effizienter Einsatz oft von der Sitzposition des Fahrzeuginsassen abhängt.

Zur Sitzbelegungserkennung in Kraftfahrzeugen werden sogenannte Sensorsitzmatten verwendet, die aus einer Vielzahl von druckempfindlichen Sensorelementen bestehen. Diese sind über die Sitzfläche eines Fahrzeugsitzes verteilt in Reihen und Spalten angeordnet und können somit die Druckeinwirkung einer Person oder eines Objekts auf der Sitzfläche erfassen.
Die einzelnen druckempfindlichen Sensorelemente einer Sensorsitzmatte bestehen zumeist aus druckabhängigen elektrischen Widerständen. Die Bestimmung des auf die Sitzfläche des Kraftfahrzeugsitzes einwirkenden Drucks erfolgt durch eine nachgeschaltete elektrische Steuereinheit. Hierzu wird die Veränderung des elektrischen Widerstands der über den Sitz verteilten Sensorelemente erfasst, was einen Rückschluss auf die auf dem Fahrzeugsitz befindliche Person ermöglicht.

Solche Sensoranordnungen in der Ausgestaltung als Sensorsitzmatte sind bekannt aus DE 200 14 200 U1 und aus dem Artikel ,Occupant Classification System for Smart Restraint System', Society of Automotive Engineers Inc. von 1999, BNSDOCID XP-002184965.

Bei der Verwendung eines derartigen Insassenerkennungssystems, muss die Wahrscheinlichkeit einer Fehlfunktion so gering wie möglich gehalten werden. Im Falle einer Fehlfunktion des Insassenerkennungssystems ist eine ernsthafte Verletzung des zu schützenden Kraftfahrzeuginsassen zu befürchten, da das Insassenerkennungssystem zumeist direkten Einfluss auf das Auslöseverhalten des Insassenrückhaltemittels in einem Kraftfahrzeug nimmt. Beispielsweise könnte ein unbemerkt erhöhter Leitungswiderstand im Strompfad zu den Sensorelementen der Sensorsitzmatte die Bestimmung des Widerstands der Sensorelemente verfälschen, wodurch ein falsches Gewichtssignal eines Kraftfahrzeuginsassen ermittelt und für die weitere Auswertung des Insassenerkennungssystems zugrundegelegt würde. Das auf diese Weise falsch bestimmte Gewicht eines Fahrzeuginsassen oder gar seine falsche Klassifizierung beispielsweise als besonders schwere und große Person könnte dazu führen, dass die Steuereinheit des Insassenschutzsystems einen Airbag zum vermeintlichen Schutz des Insassen auch dann auslöst, wenn dies für den tatsächlichen Insassen auf dem Fahrzeugsitz eher von Schaden ist.

In Sensoranordnungen zur Sitzbelegungserkennung werden deshalb bereits heute üblicherweise die Leitungswiderstände der elektrischen Zuleitungen zu den Sensorelementen in regelmäßigen Abständen überprüft.

Die europäische Offenlegungsschrift EP 0 895 091 A2 zeigt eine solche Anordnung. Dort sind in die Zuleitungen zu den Reihen und Spalten von Sensorelementen einer Sensorsitzmatte Widerstandsbauelemente angeordnet, die zusammen mit den elektrischen Leitungen den Gesamtwiderstand einer Zuleitung von Sensorelementen einer Sensorsitzmatte bilden. Der Gesamtwiderstand jeder Zuleitung zu den Sensorelementen der Sensorsitzmatte mit den darin enthaltenen Widerstandsbauelementen wird durch Messung bestimmt und mit einem Referenzwert verglichen. Dieser Referenzwert ist üblicherweise in einem Speichermedium des Insassenerkennungssystems hinterlegt und wird einer Steuereinheit nach Bedarf zur Verfügung gestellt. Beispielsweise fragt die Steuereinheit den in einem EEPROM des Insassenschutzsystems gespeicherten Referenzwert ab, um ihn anschließend mit dem gemessenen Wert zu vergleichen.

Der Referenzwert dient als Grenzwert einer Messung des Gesamtwiderstands der Zuleitung. Überschreitet der Gesamtwiderstand den Referenzwert, so wird dies beispielsweise durch eine nachgeschaltete Steuereinheit der Sensorsitzmatte erkannt.

Dieses Verfahren wird regelmäßig durchgeführt, beispielsweise vor jeder Messung der Sensorelemente, mindestens jedoch in der Hochlaufphase des Insassenerkennungssystems nach der Inbetriebnahme.

Die Verletzung des Referenzwerts (des Grenzwerts) deutet auf eine mögliche Beschädigung und so auf die Gefahr eines möglichen Fehlverhaltens der Sensorsitzmatte hin, was gegebenenfalls ein fehlerhaftes Auslöseverhalten des Insassenrückhaltemittels zur Folge haben kann. Erkennt das Insassenerkennungssystem auf diese Weise einen Fehler in der Sensorsitzmatte, so kann diese Information beispielsweise dazu verwendet werden, das Insassenschutzsystem zu deaktivieren oder nur eingeschränkt zu verwenden. Ein Fehler des Insassenerkennungssystems wird dann üblicherweise mit Hilfe einer Airbagwarnlampe für den Fahrzeuginsassen sichtbar auf einer Anzeigentafel des Kraftfahrzeuges angezeigt.

Der Gesamtwiderstand der Zuleitung zu den Sensorelementen einer Sensoranordnung und insbesondere zu den Reihen und Spalten von Sensorelementen einer Sensorsitzmatte wird im Folgenden auch als Gesamtwiderstand der Zuleitung, Gesamtwiderstand einer Reihe oder auch als Gesamtwiderstand einer Spalte bezeichnet.

Geeignete Widerstandsbauelemente für diese sogenannte Leck- oder Unterbrechungserkennungsmessung an einer Sensorsitzmatte werden vorzugsweise auf der Sensorsitzmatte integriert angeordnet und sind vom Aufbau her ähnlich wie der Aufbau der druckabhängigen Sensorelemente.

Die Messungenauigkeit macht eine Überwachung des Gesamtwiderstands der Zuleitung zu den Sensorelementen über die gesamte Betriebszeit eines Kraftfahrzeuges allerdings zu einer äußerst schwierigen messtechnischen Aufgabe. Zumeist ist die erreichte Genauigkeit in der Bestimmung des Leitungswiderstandes zu den Sensorelementen zu klein für eine sinnvolle Überwachung des Gesamtwiderstands der Zuleitung zu den Sensorelementen der Sensorsitzmatte.

Zum einen ist diese Messungenauigkeit bedingt durch eine ungenaue auswertende Elektronik zur Aufnahme des Gesamtwiderstands als Messgröße. Um die Kosten für ein Insassenerkennungssystem möglichst niedrig zu halten, wird vorzugsweise jedoch gerade nach solchen technischen Lösungen gesucht, bei denen diese ungenauen, dabei jedoch ungemein kostengünstigen Elektroniken eingesetzt werden können.

Zum anderen weisen die verwendeten Widerstandsbauelemente herstellungsbedingt eine sehr große Schwankungsbreite ihrer Widerstandswerte auf. Die Berücksichtigung der herstellungsbedingten Schwankungsbreite des Widerstandswerts der Widerstandsbauelemente kann dadurch erfolgen, dass der Gesamtwiderstandswert jedes einzelnen Widerstandsbauelements zusammen mit seinen Leitungswiderständen bei der Herstellung der Sensorsitzmatte bestimmt wird und anschließend in einem Speicher hinterlegt wird. Bei einer späteren Vergleichsmessung wird der gespeicherte Wert für das Widerstandsbauelement mit dem aktuell gemessenen Widerstandswert verglichen.

Allerdings wird dabei eine systematische Veränderung des Widerstandswerts des Widerstandsbauelements im Laufe seiner Lebensdauer innerhalb der Sensoranordnung in einem Fahrzeugsitz nicht ausreichend berücksichtigt. Der Widerstandswert des Widerstandsbauelements kann sich im Laufe seiner Lebensdauer durchaus verändern. Überschreitet der Gesamtwiderstand des Widerstandsbauelements mit seinen Leitungen dadurch einen vorher abgespeicherten Referenzwert, so würde die Steuereinheit der Sensorsitzmatte ggf. auch dann einen Fehler in der Zuleitung zu den Sensorelementen erkennen, wenn die Veränderung ausschließlich durch diese systematische Veränderung des Gesamtwiderstandswerts bewirkt worden wäre. Eine Sensorsitzmatte würde dadurch möglicherweise als fehlerhaft bewertet und eine Airbagwarnlampe ohne Grund aufleuchten.

Die Kosten für eine unnötige Reparatur oder einen Austausch einer fehlerfreien Sensorsitzmatte sind nicht nur unnötig, sondern meist auch nicht unerheblich und sollten deshalb möglichst vermieden werden

Eine Verbesserung der bisherigen Methode der Widerstandsüberwachung der elektrischen Zuleitung von Sensorelementen stellt eine Überwachung der Abweichungen von den gespeicherten Referenzwerten dar, bei der die Abweichung des gemessenen Gesamtwiderstands für jedes Widerstandsbauelement mit der Abweichung für alle anderen Widerstandsbauelemente verglichen wird. Unterscheidet sich die Abweichung des Gesamtwiderstands für ein Widerstandbauelement wesentlich von dem der anderen, so handelt es sich nicht um eine systematische Veränderung des Gesamtwiderstandes, sondern deutet auf einen Fehler innerhalb der betroffenen elektrischen Zuleitung hin. Bei dieser Vorgehensweise werden alle systematischen Veränderungen der Widerstandsbauelemente und ihrer Leitungen berücksichtigt, die beispielsweise duch Temperturschwankungen und Materialalterung, etc. verursacht werden.

Vorteilhafterweise werden außerdem gleichzeitig Fehler der Messelektronik sowohl bei der anfänglichen Bestimmung der Referenzwerte als auch bei den später wiederholt durchgeführten Vergleichsmessungen entsprechend berücksichtigt.
Die Gefahr einer falschen Gewichtsauswertung durch das Insassenschutzsystem wird bei diesem Verfahren um ein Wesentliches verringert.

Die beiden beschriebenen Vorgehensweisen sind fertigungstechnisch jedoch äußerst aufwändig und aus Kostengründen meist nicht umsetzbar.

Der Erfindung liegt deshalb die Aufgabe zugrunde, ein möglichst einfaches Verfahren sowie eine zugrunde liegende Sensoranordnung zu schaffen, die eine Überwachung eines Widerstandswertes einer Zuleitung zu Sensorelementen innerhalb einer Sensoranordnung zur Sitzbelegungserkennung über die gesamte Lebensdauer der Sensoranordnung derart erlaubt, dass eine Erhöhung des Leitungswiderstandes einer Zuleitung schnell und sicher erkannt wird.

Der das Verfahren betreffende Teil der Aufgabe wird gelöst durch die Merkmale des Anspruchs 1.

Bei einer Anordnung von Sensorelementen wird dabei der elektrische Gesamtwiderstand der Zuleitung zu den Sensorelementen durch Messung ermittelt. Der Gesamtwiderstand der Zuleitung setzt sich sowohl aus den elektrischen Widerständen der Leitungen zu den Sensorelementen zusammen als auch aus dem elektrischen Widerstand eines oder mehrerer elektronischer Bauelemente im Strompfad zu und von den Sensorelementen, insbesondere von Widerstandsbauelementen.

Der so ermittelte elektrische Gesamtwiderstand der Zuleitung zu den Sensorelementen wird mit einem Referenzwert verglichen, der durch den elektrischen Gesamtwiderstand eines Referenzbauelements und dessen elektrischer Leitungen ermittelt wird.

Ein Referenzbauelement ist dabei ein zunächst beliebiges elektronisches Bauelement im Strompfad der Zuleitung von Sensorelementen, dessen Widerstandswert genauer angegeben werden kann und sich während der gesamten Dauer seiner Verwendung weniger verändert als der Widerstandswert der Mehrzahl der übrigen Bauelemente der Schaltung in ähnlicher Verwendung. Üblicherweise handelt es sich bei einem Referenzbauelement folglich gleichermaßen um ein Widerstandsbauelement in einer Zuleitung zu Sensorelementen. Im Unterschied zu den anderen vergleichbaren Widerstandsbauelementen in einer Zuleitung zu Sensorelementen verändert sich der Widerstandwert eines Referenzbauelements bei sonst gleichen äußeren Einflüssen jedoch nur sehr wenig. Sein Widerstandswert bleibt vorzugsweise innerhalb eines Toleranzbereichs von 1% um seinen Sollwert, während die verwendeten Widerstandbauelemente auf einer Sensorsitzmatte einen Toleranzbereich von durchaus 25% um ihren Nennwert aufweisen können.

Die elektrische Beschaltung eines Referenzbauelements unterscheidet sich im elektrischen Aufbau nicht von der der üblicherweise verwendeten Widerstandselemente.

Wahlweise können die Referenzbauelemente in der Technologie der bekannten Widerstandbauelemente auf der Sensorsitzmatte integriert sein, sie können aber auch als Bauelemente auf einer ausgelagerten Leiterplatte angeordnet sein, so dass lediglich ihre elektrische Anbindung an die Sensorelemente gleich der der übrigen Widerstandsbauelemente ist. Besonders günstig ist insbesondere eine Anordnung innerhalb einer Steuereinheit des Insassenschutzsystems.

Ein Referenzbauelement ist innerhalb der Zuleitung zu Sensorelementen einer Sensorsitzmatte folglich schaltungstechnisch an der Stelle eines üblichen Widerstandelements mit hohem Toleranzbereich eingefügt. Der Widerstand der Leitungen ist dabei vorzugsweise möglichst niederohmig. Im Idealfall weisen das herkömmliche Widerstandelement und das Referenzbauelement den gleichen Nennwert ihres Widerstands auf. Bei einer vergleichenden Messung wird die Differenz des Gesamtwiderstands einer Zuleitung mit herkömmlichem Widerstandselement mit dem Gesamtwiderstand einer Zuleitung mit Referenzbauelement, dem Referenzwert, ermittelt. Liegt die Differenz beider Werte außerhalb von vorher festgelegten Grenzwerten, deutet dies auf einen Fehler innerhalb der Zuleitung einer Reihe oder Spalte von Sensorelementen hin.

Vorzugsweise dient der Referenzwert der vergleichenden Messung als oberer oder auch als unterer Grenzwert des elektrischen Gesamtwiderstands der Zuleitung zu den Sensorelementen.

Eine der Sensorsitzmatte nachgeschaltete Steuereinheit kann dabei ein Über- oder Unterschreiten dieses Referenzwerts (Grenzwerts) erkennen. Wird der Referenzwert auf diese Weise über- oder unterschritten, so wird dies als Signal für einen Fehler in der Zuleitung zu den jeweiligen Sensorelementen an eine nachgeschaltete Steuereinheit gemeldet.

In einer weiteren Ausbildung des erfindungsgemäßen Verfahrens wird der elektrische Gesamtwiderstand der Zuleitung zu den Sensorelementen mit einem weiteren Referenzwert verglichen. Auch dieser weitere Referenzwert ist der Wert des elektrischen Gesamtwiderstands eines weiteren Referenzbauelements der Schaltungsanordnung und seiner elektrischen Zuleitung. Auch dieser weitere Referenzwert wird durch Messung ermittelt. Auch dieser weitere Referenzwert stellt einen unteren oder einen oberen Grenzwert des elektrischen Gesamtwiderstands der Zuleitung zu den Sensorelementen dar. Auch im Falle des weiteren Referenzwertes gilt ein Überschreiten oder ein Unterschreiten des weiteren Referenzwertes durch den Gesamtwiderstand der Zuleitung zu den Sensorelementen als ein Signal für einen Fehler in der Sensoranordnung und wird an die nachgeschaltete Steuereinheit gemeldet.

Vorzugsweise werden der Referenzwert und der weitere Referenzwert gleichzeitig für die Überwachung des elektrischen Gesamtwiderstands der Zuleitung zu den Sensorelementen einer Sensorsitzmatte verwendet. Sowohl der Referenzwert als auch der weitere Referenzwert umfasst dabei den elektrischen Gesamtwiderstand des Referenzbauelements beziehungsweise eines weiteren Referenzbauelements der Schaltungsanordnung und den jeweiligen elektrischen Zuleitungen zu diesen beiden elektrischen Referenzbauelementen. Wie bei der Verwendung nur eines Referenzwertes werden beide Referenzwerte jeweils durch Messung ermittelt.

Einer der beiden Referenzwerte stellt nun einen oberen Grenzwert des elektrischen Gesamtwiderstands der Zuleitung zu den Sensorelementen dar, der jeweils andere Referenzwert den unteren Grenzwert. Eines der beiden elektronischen Referenzbauelemente kann dabei das Über- oder Unterschreiten des oberen Grenzwerts an eine nachgeschaltete Steuereinheit signalisieren, das jeweils andere Referenzbauelement das Über- oder Unterschreiten des unteren Grenzwerts. Durch dieses Verfahren kann überwacht werden, ob sich der elektrische Gesamtwiderstand der Zuleitung zu den Sensorelementen der Sensoranordnung innerhalb eines für die Anwendung zulässigen Wertebereichs befindet. Der Wertebereich wird dabei durch den oberen und unteren Grenzwert definiert, der jeweils entweder durch den Referenzwert oder den weiteren Referenzwert in der Schaltung gebildet wird.

Üblicherweise sind die Sensorelemente einer Sensoranordnung zur Insassenerkennung in einem Kraftfahrzeug matrixartig in Reihen und Spalten angeordnet. Bei einer solchen Anordnung der Sensorelemente wird das erfindungsgemäße Verfahren zur Bestimmung des elektrischen Gesamtwiderstands einer elektrischen Zuleitung zu Sensorelementen jeweils auf die Sensorelemente einer Reihe oder einer Spalte durchgeführt. Auf diese Weise kann der Gesamtwiderstand der Zuleitung jeder Reihe und jeder Spalte einzeln durch Messung bestimmt werden und über die gesamte Betriebszeit eines Kraftfahrzeuges überwacht werden.

Der die Sensoranordnung betreffende Teil der Aufgabe wird gelöst durch eine flächige Sensoranordnung, insbesondere durch eine Sensorsitzmatte zur Sitzbelegungserkennung in einem Kraftfahrzeug mit den Merkmalen nach Anspruch 15.
Die Sensorelemente sind matrixartig in Reihen und Spalten angeordnet mit elektrischen Zuleitungen zu jeder Reihe und jeder Spalte von Sensorelementen, die jeweils ein elektronisches Bauelement aufweisen. Entsprechend dem oben beschriebenen Verfahren dienen diese elektronischen Widerstandsbauelemente in den Zuleitungen zu den Reihen und Spalten von Sensorelementen zur Bestimmung des elektrischen Gesamtwiderstands der Zuleitung zu den Sensorelementen jeder Reihe und jeder Spalte. Mindestens eines dieser elektronischen Widerstandsbauelemente dient dabei als Referenzbauelement.

Vorzugsweise wendet eine Steuereinheit das erfindungsgemäße Verfahren auf diese Sensoranordnung an.

Die Erfindung wird nachfolgend anhand eines ausgewählten Ausführungsbeispiels dargestellt.
Es zeigen:
- Figur 1: eine erfindungsgemäße Sensoranordnung, auf die das erfindungsgemäße Verfahren Anwendung findet und
- Figur 2: ein Ablaufdiagramm des erfindungsgemäßen Verfahrens

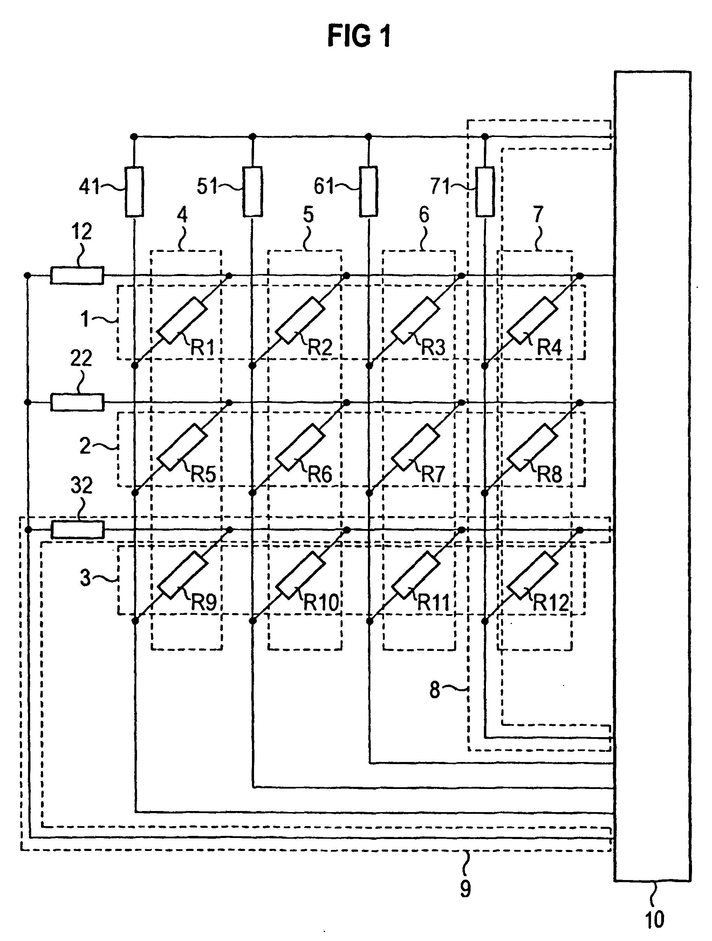

Figur 1 zeigt eine erfindungsgemäße Sensoranordnung als Sensorsitzmatte, die dazu geeignet ist, das erfindungsgemäße Verfahren auf sie anzuwenden. Dargestellt ist eine Sensoranordnung bestehend aus druckempfindlichen Sensorelementen R1 bis R12. Die Sensorelemente R1 bis R12 sind in drei Reihen und vier Spalten angeordnet. In Figur 1 sind die Reihen 1, 2 und 3 sowie die Spalten 4 bis 7 gestrichelt gekennzeichnet.

Jede Spalte und jede Reihe besitzt je eine elektrische Zuleitung, die ihre Sensorelemente mit der Steuereinheit 10 verbindet. Jede Zuleitung weist ein elektronisches Bauelement auf, hier in Form der Widerstandsbauelemente 41 bis 71 für die Spalten 4 bis 7 und in Form der Widerstandsbauelemente 12 bis 32 für die Reihen 1 bis 3.

Beispielhaft für die Zuleitung zu Sensorelementen ist die Zuleitung 9 zu der Reihe 3 von Sensorelementen gestrichelt gekennzeichnet sowie die Zuleitung 8 zu der Spalte 7 von Sensorelementen. Die entsprechenden Zuleitungen zu den übrigen Reihen 1 bis 2 und Spalten 4 bis 6 sind in der Figur 1 nicht gesondert gekennzeichnet, um die Übersichtlichkeit der Darstellung nicht unnötig zu erschweren.

Üblicherweise besitzen die Sensorelemente R1 bis R12 unter Einwirken einer Gewichtskraft Widerstandswerte zwischen 5 und 500 kOhm. Ohne Krafteinwirkung ist der ohmsche Widerstand der Sensorzellen im Idealfall unendlich, da die Flächen der Sensorzellen sich nicht elektrisch kontaktieren.

Die meisten Widerstandsbauelemente 41 bis 71 und 12 bis 32 in den Zuleitungen zu den Spalten beziehungsweise Reihen von Sensorelementen weisen Widerstandswerte zwischen 2 bis 6 kohm auf.

Um das erfindungsgemäße Verfahren, d. h. eine Überwachung der Widerstandsbauelemente 41 bis 71 und 12 bis 32 durchführen zu können, weist nun mindestens ein Widerstandsbauelement der Sensoranordnung einen engeren Toleranzbereich seines Widerstandswerts auf.
Im gezeigten Ausführungsbeispiel sind dies die beiden Referenzbauelemente 41 und 32. Gemeinsam mit ihrer jeweiligen Zuleitung von und zu der Steuereinheit 10 weisen beide Referenzbauelemente einen elektrischen Gesamtwiderstandswert auf. Die Gesamtwiderstände der beiden Referenzbauelemente 41 und 32 stellen die Referenzwerte für eine vergleichende Widerstandsmessung der elektrischen Zuleitungen zu den Spalten 4 bis 7 und Reihen 1 bis 3 von Sensorelementen dar. Dabei definiert der Referenzwert zum Widerstandsbauelement 41 einen oberen Grenzwert und der Referenzwert zum Widerstandsbauelement 32 einen unteren Grenzwert.

Im erfindungsgemäßen Verfahren wird nun der Gesamtwiderstand der Zuleitungen zu den Spalten 5 bis 7 und Reihen 1 bis 2 mit dem oberen Referenzwert und dem unteren Referenzwert verglichen. Liegt einer der Widerstandswerte des Gesamtwiderstands der Zuleitung einer Reihe oder einer Spalte nicht innerhalb eines Intervalls zwischen dem oberen und dem unteren Referenzwert so erkennt dies die Steuereinheit 10. Das Verlassen dieses Referenzwertintervalls deutet auf eine mögliche Fehlfunktion der Sensorsitzmatte hin, was ggf. zu einer falschen Auslöseentscheidung des Insassenrückhaltemittels führen kann.

Um mögliche schädliche Folgen für einen Fahrzeuginsassen zu vermeiden, wird nun üblicherweise entweder das Insassenrückhaltesystem (Airbagsystem) deaktiviert oder es wird im folgenden Betrieb nur mit eingeschränkter Funktionalität verwendet. Dies kann beispielsweise in der Art erfolgen, dass die Steuerung des Insassenrückhaltemittels ein eigens dafür vorher festgelegtes modifiziertes Auslöseverhalten aufweist, dass den ohne eine Information des Sitzbelegungserkennungssystems bestmöglichen Schutz für den Kraftfahrzeuginsassen bietet.

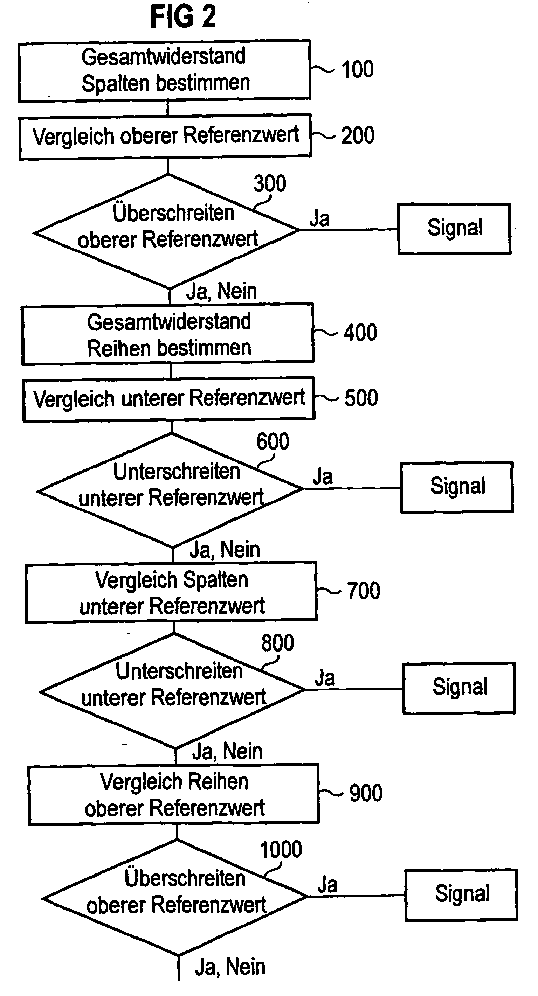

Figur 2 zeigt ein Ablaufdiagramm des erfindungsgemäßen Verfahrens unter Bezugnahme auf die Elemente der Sensoranordnung nach Figur 1. Das Verfahren läuft wie folgt ab:
- Verfahrensschritt 100: Bestimmung des jeweiligen Gesamtwiderstands der Zuleitungen zu den Spalten 4 bis 7,
- Verfahrensschritt 200: Vergleich des jeweiligen Gesamtwiderstands jeder Zuleitung zu jeder Spalte mit dem oberen Referenzwert, das heißt mit dem Gesamtwiderstand der Zuleitung zu der Spalte 4,
- Verfahrensschritt 300: überschreitet der Gesamtwiderstand der Zuleitung einer Spalte den oberen Referenzwert so erkennt dies die Steuereinheit 10 und gibt ein Signal an das Insassenrückhaltesystem,
- Verfahrensschritt 400: Bestimmung des jeweiligen Gesamtwiderstands der Zuleitungen zu den Reihen 1 bis 3,
- Verfahrensschritt 500: Vergleich des Gesamtwiderstands jeder Zuleitung zu jeder Reihe mit dem unteren Referenzwert, das heißt mit dem Gesamtwiderstand der Zuleitung zu der Reihe 3,
- Verfahrensschritt 600: liegt einer der Gesamtwiderstände der Zuleitungen zu einer Reihe unter dem unteren Referenzwert so erkennt dies die Steuereinheit 10 und gibt ein Signal an das Insassenrückhaltesystem aus,
- Verfahrensschritt 700: Vergleich des jeweiligen Gesamtwiderstands der Zuleitungen zu den Spalten 5 bis 7 mit dem unteren Referenzwert,
- Verfahrensschritt 800: liegt einer der Gesamtwiderstände einer der Spalten 5 bis 7 unter dem unteren Referenzwert so wird dies durch die Steuereinheit 10 erkannt und an das Insassenrückhaltesystem signalisiert,
- Verfahrensschritt 900: Vergleich des jeweiligen Gesamtwiderstands der Zuleitungen zu den Reihen 1 und 2 mit dem oberen Referenzwert,
- Verfahrensschritt 1000: liegt einer der Gesamtwiderstände der genannten Reihen über dem oberen Referenzwert so registriert dies die Steuereinheit 10 und gibt ein Signal an das Insassenrückhaltesystem aus.

Eine Modifikation des Verfahrens ist dabei selbstverständlich jederzeit denkbar, beispielsweise sind einzelne Verfahrensschritte miteinander vertauschbar.

Wahlweise kann auch das Referenzbauelement 41 den unteren Referenzwert vorgeben und entsprechend das Referenzbauelement 32 zur Bildung des oberen Referenzwertes dienen, wobei das oben beschriebene Verfahren entsprechend umgestellt werden muss.

Des Weiteren ist auch eine Anordnung je eines Referenzbauelements in einer Spalte und einer Reihe nicht zwingend für die Durchführung des erfindungsgemäßen Verfahrens. Deshalb können durchaus beide Referenzbauelemente in je einer Spalte oder je einer Reihe angeordnet sein.

Die beschriebene Sensoranordnung ist weder auf eine bestimmte Anzahl von Sensorelementen noch auf eine feste Anzahl von Reihen und Spalten von Sensorelementen beschränkt.

## Patentansprüche

1. Verfahren zur Bestimmung des elektrischen Widerstandes einer elektrischen Zuleitung (8, 9,...) zu Sensorelementen (R1,...R12) , bei dem
- die Sensorelemente (R1,...R12) zu einer Sensoranordnung zusammengeschaltet sind,
- der elektrische Gesamtwiderstand der Zuleitung (8, 9,...) zu den Sensorelementen (R1,...R12) durch Messung ermittelt wird, wobei der Gesamtwiderstand sowohl den elektrischen Widerstand einer elektrischen Leitung (8, 9,...) zu den Sensorelementen (R1,...R12) umfasst als auch den elektrischen Widerstand eines elektronischen Bauelements (12, 22, 32, 41, 51, 61, 71), das in dem durch die elektrischen Leitungen vorgegebenen Strompfad angeordnet ist, und
- der elektrische Gesamtwiderstand der Zuleitung (8, 9...) zu den Sensorelementen (R1,...R12) mit einem Referenzwert verglichen wird,
**dadurch gekennzeichnet, dass** der Referenzwert der Wert des elektrischen Gesamtwiderstands eines Referenzbauelements (41) der Schaltungsanordnung und seiner elektrischen Leitung (8, 9,...) ist und der Referenzwert durch Messung ermittelt wird.

2. Verfahren nach Anspruch 1, bei dem der Referenzwert einen oberen Grenzwert des elektrischen Gesamtwiderstands der Zuleitung (8, 9,...) zu den Sensorelementen (R1,...R12) darstellt.

3. Verfahren nach Anspruch 2, bei dem ein Signal an eine nachgeschaltete Steuereinheit (10) bereitgestellt wird sobald der obere Referenzwert durch den gemessenen Gesamtwiderstand der Zuleitung (8, 9,...) überschritten wird.

4. Verfahren nach einem der Ansprüche 1 bis 3, bei dem
- der elektrische Gesamtwiderstand der Zuleitung (8, 9,...) zu den Sensorelementen (R1,...R12) mit einem weiteren Referenzwert verglichen wird, wobei der weitere Referenzwert der Wert des elektrischen Gesamtwiderstands eines weiteren Referenzbauelements (32) der Schaltungsanordnung und seiner elektrischen Leitung (8, 9,...) ist und
- der weitere Referenzwert durch Messung ermittelt wird.

5. Verfahren nach Anspruch 4, bei dem der weitere Referenzwert einen unteren Grenzwert des elektrischen Gesamtwiderstands der Zuleitung (8, 9,...) zu den Sensorelementen (R1,...R12) darstellt.

6. Verfahren nach Anspruch 5, bei dem ein Signal an die nachgeschaltete Steuereinheit (10) bereitgestellt wird sobald der untere Referenzwert durch den gemessenen Gesamtwiderstand der Zuleitung (8, 9,...) unterschritten wird.

7. Verfahren nach Anspruch 1, bei dem der Referenzwert einen unteren Grenzwert des elektrischen Gesamtwiderstands der Zuleitung (8, 9,...) zu den Sensorelementen (R1,...R12) darstellt.

8. Verfahren nach Anspruch 7, bei dem ein Signal an eine nachgeschaltete Steuereinheit (10) bereitgestellt wird sobald der untere Referenzwert unterschritten wird.

9. Verfahren nach einem der Ansprüche 1, 7 oder 8, bei dem
- der elektrische Gesamtwiderstand der Zuleitung (8, 9,...) zu den Sensorelementen (R1,...R12) mit einem weiteren Referenzwert verglichen wird,
- der weitere Referenzwert der Wert des elektrischen Gesamtwiderstands eines weiteren Referenzbauelements (32) der Schaltungsanordnung und seiner elektrischen Leitung (8, 9,...) ist und
- der weitere Referenzwert durch Messung ermittelt wird.

10. Verfahren nach Anspruch 9, bei dem der weitere Referenzwert einen oberen zulässigen Grenzwert des elektrischen Gesamtwiderstands der Zuleitung (8, 9,...) zu den Sensorelementen (R1,...R12) darstellt.

11. Verfahren nach Anspruch 10, bei ein Signal an die nachgeschaltete Steuereinheit (10) bereitgestellt, sobald der obere Referenzwert durch den gemessenen Gesamtwiderstand der Zuleitung (8, 9,...) überschritten wird.

12. Verfahren nach einem der vorhergehenden Ansprüche, bei dem
- die Sensorelemente (R1,...R12) der Sensoranordnung matrixartig in Reihen (1, 2, 3) und Spalten (4, 5, 6, 7) angeordnet sind,
- jede Reihe (1, 2, 3) und jede Spalte (4, 5, 6, 7) eine elektrische Zuleitung (8, 9,...) zu ihren Sensorelementen (R1,...R12) aufweist,
- der Gesamtwiderstand der Zuleitung (8, 9,...) jeder Reihe (1, 2, 3) und Spalte (4, 5, 6, 7) einzeln durch Messung bestimmt wird.

13. Verfahren nach Anspruch 12, bei dem für die Zuleitung jeder Reihe (1, 2, 3) und jeder Spalte (4, 5, 6, 7) von Sensorelementen (R1,...R12) ein Verfahren nach einem der Ansprüche 1 bis 6 durchgeführt wird.

14. Verfahren nach Anspruch 12, bei dem für die Zuleitung jeder Reihe (1, 2, 3) und jeder Spalte (4, 5, 6, 7) von Sensorelementen (R1,...R12) ein Verfahren nach einem der Ansprüche 7 bis 11 durchgeführt wird.

15. Flächige Sensoranordnung, insbesondere Sensorsitzmatte zur Sitzbelegungserkennung in einem Kraftfahrzeug mit
- Sensorelementen (R1,...R12), die matrixartig in Reihen (1, 2, 3) und Spalten (4, 5, 6, 7) angeordnet sind und
- je einer elektrischen Zuleitung (8, 9,...) zur jeder Reihe (1, 2, 3) und jeder Spalte (4, 5, 6, 7) von Sensorelementen (R1,...R12),
wobei
- jede Zuleitung (8, 9,...) ein elektronisches Bauelement (12, 22, 32, 41, 51, 61, 71) enthält und
- mindestens ein elektronisches Bauelement (41, 32) davon als ein Referenzbauelement ausgebildet ist,
**dadurch gekennzeichnet, dass** die Sensoreinheit eine Steuereinheit (10) zur Durchführung eines Verfahrens nach den Ansprüchen 1 bis 13 aufweist.

## Claims

1. Method for determining the electrical resistance of an electrical supply lead (8,9,...) to sensor elements (R1,...R12), in which
- the sensor elements (R1,...R12) are interconnected to form a sensor arrangement
- the overall electrical resistance of the supply lead (8,9,...) to the sensor elements (R1, ...R12 ) is determined by measurement, in which case the overall resistance includes both the electrical resistance of an electrical line (8,9,...) to the sensor elements (R1,...R12) and also the electrical resistance of an electronic component (12, 22, 32, 41, 51, 61, 71), which is arranged in the current path specified by the electrical line,
- the overall electrical resistance of the supply lead (8,9,...) to the sensor elements (R1,...R12) is compared to a reference value,
**characterized in that** the reference value is the value of the overall electrical resistance of a reference component (41) of the circuit arrangement and its electrical line (8,9,...)and the reference value is determined through measurement.

2. Method in accordance with claim 1, in which the reference value represents an upper limit value of the overall electrical resistance of the supply lead (8,9,...) to the sensor elements (R1,...R12).

3. Method in accordance with claim 2, in which a signal to a downstream control unit (10) is provided as soon as the upper reference value is exceeded by the measured overall resistance of the supply lead (8,9...).

4. Method in accordance with one of the claims 1 to 3, in which
- the overall electrical resistance of the supply lead (8,9,...) to the sensor elements (R1,...R12) is compared to a further reference value, in which case the further reference value is the value of the overall electrical resistance of a further reference component (32) of the circuit arrangement and its electrical line (8,9...) and
- the further reference value is determined through measurement.

5. Method in accordance with claim 4, in which the further reference value represents a lower limit value of the overall electrical resistance of the supply lead (8,9,...) to the sensor elements (R1,...R12).

6. Method in accordance with claim 5, in which a signal is provided to the downstream control unit (10) as soon as the lower reference value is undershot by the measured overall resistance of the supply lead (8, 9,...).

7. Method in accordance with claim 1, in which the reference value represents a lower limit value of the overall electrical resistance of the supply lead (8,9,...) to the sensor elements (R1,...R12) .

8. Method in accordance with claim 7, in which a signal is provided to a downstream control unit (10) as soon as the lower reference value is undershot.

9. Method in accordance with one of the claims 1, 7 or 8, in which
the overall electrical resistance of the supply lead (8,9,...) to the sensor elements (R1,...R12) is compared with a further reference value.
- the further reference value is the value of the overall electrical resistance of a further reference component (32) of the circuit arrangement and its electrical line (8,9,...) and
- the further reference value is determined through measurement.

10. Method in accordance with claim 9, in which the further reference value represents an upper permitted limit value of the overall electrical resistance of the supply lead (8,9,...) to the sensor elements (R1,...R12).

11. Method in accordance with claim 10, in which a signal to the downstream control unit (10) is provided as soon as the upper reference value is exceeded by the measured overall resistance of the supply lead (8,9,...).

12. Method according to one of the previous claims in which
- the sensor elements (R1,...R12) of the sensor arrangement are arranged in the form of a matrix of rows (1,2,3,) and columns (4,5,6,7),
- each row (1,2,3) and each column (4,5,6,7) features an electrical supply lead (8,9,...) to its sensor elements (R1,...R12) ,
- the overall resistance of the supply lead (8,9,...) of each row (1,2,3) and column (4,5,6,7) is determined individually by measurement.

13. Method in accordance with claim 12, in which, for the supply lead of each row (1,2,3) and each column (4,5,6,7) of sensor elements (R1,...R12), a method in accordance with one of the claims 1 to 6 is executed.

14. Method in accordance with claim 12, in which, for the supply lead of each row (1,2,3) and each column (4,5,6,7) of sensor elements (R1,...R12), a method in accordance with one of the claims 7 to 11 is executed.

15. Flat sensor arrangement, especially sensor seat mat for detecting seat occupancy in a motor vehicle with
- sensor elements (R1,...R12), arranged in a matrix of rows (1,2,3) and columns (4,5,6,7),
- one electrical supply lead (8,9,...) to each row (1,2,3) and
to each column (4,5,6,7) of sensor elements (R1,...R12), where
- each supply lead (8,9,...) contains and electronic component (12,22,32,41,51,61,71) and
- at least one of these electronic components (41, 32) is embodied as a reference component.
**characterised in that**
the sensor unit comprises a control unit (10) for executing a method according to one of claims 1 to 13.

## Revendications

1. Procédé pour déterminer la résistance électrique d'une ligne d'alimentation électrique (8, 9,...) pour les éléments capteurs (R1,..., R12), dans lequel
- les éléments capteurs (R1,..., R12) sont connectés ensemble pour former un agencement de capteurs,
- la résistance globale électrique de la ligne d'alimentation (8, 9,...) pour les éléments capteurs (R1, ..., R12) est obtenue par mesure, la résistance globale comprenant aussi bien la résistance électrique d'une ligne électrique (8, 9,...) pour les éléments capteurs (R1,..., R12) que la résistance électrique d'un composant électronique (12, 22, 32, 41, 51, 61, 71), qui est disposée dans le trajet du courant prédéfini par les lignes électriques, et
- la résistance globale électrique de la ligne d'alimentation (8, 9,...) pour les éléments capteurs (R1,..., R12) est comparée avec une valeur de référence,
**caractérisé en ce que** la valeur de référence est la valeur de la résistance globale électrique d'un composant de référence (41) de l'agencement du circuit et de sa ligne électrique (8, 9,...) et la valeur de référence est obtenue par mesure.

2. Procédé selon la revendication 1, dans lequel la valeur de référence représente une valeur limite supérieure de la résistance globale électrique de la ligne d'alimentation (8, 9,...) pour les éléments capteurs (R1,..., R12).

3. Procédé selon la revendication 2, dans lequel un signal est envoyé à une unité de commande (10) placée en aval dès que la valeur de référence supérieure est dépassée par la résistance globale mesurée de la ligne d'alimentation (8, 9,...).

4. Procédé selon l'une quelconque des revendications 1 à 3,
dans lequel
- la résistance globale électrique de la ligne d'alimentation (8, 9,...) pour les éléments capteurs (R1,..., R12) est comparée avec une autre valeur de référence, l'autre valeur de référence étant la valeur de la résistance globale électrique d'un autre composant de référence (32) de l'agencement du circuit et de sa ligne électrique (8, 9,...) et
- l'autre valeur de référence est déterminée par mesure.

5. Procédé selon la revendication 4, dans lequel l'autre valeur de référence représente une valeur limite inférieure de la résistance globale électrique de la ligne d'alimentation (8, 9,...) pour les éléments capteurs (R1,..., R12).

6. Procédé selon la revendication 5, dans lequel un signal est envoyé à l'unité de commande (10) montée en aval dès que la valeur de référence inférieure est sous-dépassée par la résistance globale mesurée de la ligne d'alimentation (8, 9,...).

7. Procédé selon la revendication 1, dans lequel la valeur de référence représente une valeur limite inférieure de la résistance globale électrique de la ligne d'alimentation (8, 9,...) pour les éléments capteurs (R1,..., R12).

8. Procédé selon la revendication 7, dans lequel un signal est envoyé à une unité de commande (10) montée en aval dès que la valeur de référence inférieure est sous-dépassée.

9. Procédé selon l'une quelconque des revendications 1, 7 ou 8,
dans lequel
- la résistance globale électrique de la ligne d'alimentation (8, 9,...) pour les éléments capteurs (R1,..., R12) est comparée avec une autre valeur de référence,
- l'autre valeur de référence est la valeur de la résistance globale électrique d'un autre composant de référence (32) de l'agencement du circuit et de sa ligne électrique (8, 9,...) et
- l'autre valeur de référence est déterminée par mesure.

10. Procédé selon la revendication 9, dans lequel l'autre valeur de référence représente une valeur limite autorisée supérieure de la résistance globale électrique de la ligne d'alimentation (8, 9,...) pour les éléments capteurs (R1, ..., R12).

11. Procédé selon la revendication 10, dans lequel un signal est envoyé à l'unité de commande (10) montée en aval dès que la valeur de référence supérieure est sous-dépassée par la résistance globale mesurée de la ligne d'alimentation (8, 9,...) .

12. Procédé selon l'une quelconque des revendications précédentes, dans lequel
- les éléments capteurs (R1,..., R12) de l'agencement de capteurs sont disposés à la façon d'une matrice en rangées (1, 2, 3) et colonnes (4, 5, 6, 7),
- chaque rangée (1, 2, 3) et chaque colonne (4, 5, 6, 7) présentent une ligne d'alimentation électrique (8, 9,...) pour leurs éléments capteurs (R1, ..., R12),
- la résistance globale de la ligne d'alimentation (8, 9,...) de chaque rangée (1, 2, 3) et de chaque colonne (4, 5, 6, 7) est déterminée individuellement par mesure.

13. Procédé selon la revendication 12, dans lequel, pour la ligne d'alimentation de chaque rangée (1, 2, 3) et de chaque colonne (4, 5, 6, 7) d'éléments capteurs (R1,..., R12), on met en oeuvre un procédé selon l'une quelconque des revendications 1 à 6.

14. Procédé selon la revendication 12, dans lequel, pour la ligne d'alimentation de chaque rangée (1, 2, 3) et de chaque colonne (4, 5, 6, 7) d'éléments capteurs (R1,..., R12), on met en oeuvre un procédé selon l'une quelconque des revendications 7 à 11.

15. Agencement de capteurs plat, en particulier tapis de siège à capteurs pour la détection d'occupation de siège sur un véhicule automobile comprenant
- des éléments capteurs (R1,..., R12), qui sont disposés à la façon d'une matrice en rangées (1, 2, 3) et colonnes (4, 5, 6, 7) et
- une ligne d'alimentation électrique (8, 9,...) pour chaque rangée (1, 2, 3) et chaque colonne (4, 5, 6, 7) d'éléments capteurs (R1,..., R12),
- chaque ligne d'alimentation (8, 9,...) contenant un composant (12, 22, 32, 41, 51, 61, 71) électronique et
- au moins un composant (41, 32) électronique de ces composants étant conçu comme un composant de référence,
**caractérisé en ce que** l'unité de capteurs présente une unité de commande (10) pour la mise en oeuvre d'un procédé selon les revendications 1 à 13.
